# EUROPEAN PATENT SPECIFICATION

(11) **EP 2 249 478 B1**
(45) Date of publication and mention of the grant of the patent: **07.01.2015**
(21) Application number: 08711633.1
(22) Date of filing: 20.02.2008
(51) Int. Cl.: H03H 9/05, H03H 9/70, H03H 9/72

(54) **FILTER, BRANCHING FILTER, COMMUNICATION MODULE, AND COMMUNICATION EQUIPMENT**
FILTER, ABZWEIGFILTER, KOMMUNIKATIONSMODUL UND KOMMUNIKATIONSGERÄT
FILTRE, FILTRE DE BRANCHEMENT, MODULE DE COMMUNICATION, ET ÉQUIPEMENT DE COMMUNICATION

(43) Date of publication of application: 10.11.2010
(73) Proprietor: Taiyo Yuden Co., Ltd., Tokyo 110-0005 (JP)
(72) Inventor: TSUTSUMI, Jun, Ueno, Taito-ku Tokyo 1100005 (JP); MATSUMOTO, Kazuhiro, Ueno, Taito-ku Tokyo 1100005 (JP)
(74) Representative: Müller-Boré & Partner Patentanwälte PartG mbB
(86) International application number: PCT/JP2008/052827
(87) International publication number: WO 2009/104251

(56) References cited:
- EP-A2- 1 675 262
- WO-A1-2008/001897
- JP-A- 2004 166 258
- JP-A- 2004 166 258
- JP-A- 2005 151 287
- JP-A- 2005 183 949
- JP-A- 2005 277 522
- US-A1- 2004 212 451
- US-A1- 2006 076 668
- US-A1- 2009 147 707

## Description

### TECHNICAL FIELD

The present invention relates to a filter such as a high-frequency filter used for mobile communication equipment or radio equipment represented by a mobile phone. Also, the invention relates to a duplexer using such a filter. Also, the invention relates to a communication module and a communication device in which such a filter or duplexer is built.

### BACKGROUND ART

In recent years, a multiband/multisystem advances for radio communication equipment represented by a mobile phone terminal, and a plurality of communication devices are mounted in one terminal. However, the mobile phone terminal itself is continuously demanded to achieve a reduction in size and thickness, and it is a situation that the reduction in size and thickness of a communication device mounted therein is eagerly demanded. Under such a background, a reduction in size and thickness of a component used for the communication device becomes essential, and a reduction in size and thickness of a high-frequency filter or duplexers as a principal part is eagerly desired.

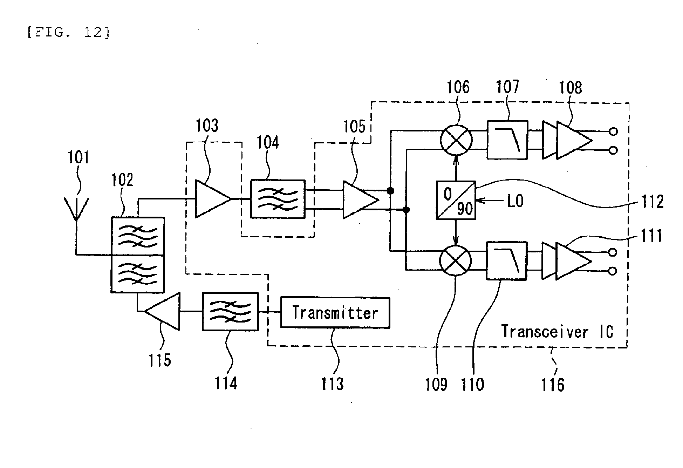

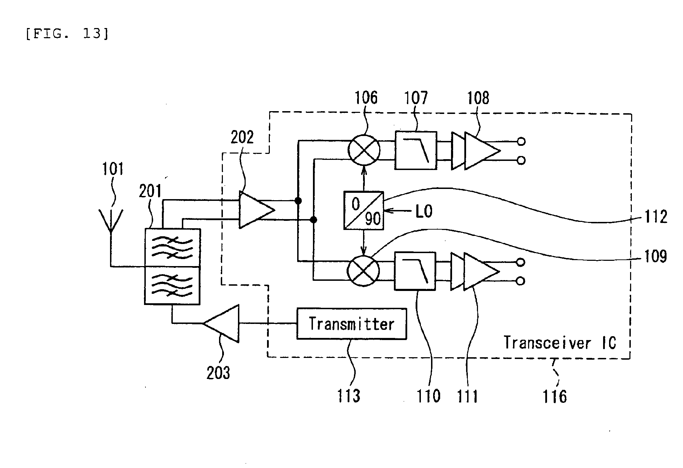

As another method for achieving a reduction in size of the communication device, there is a tendency to simplify the communication device and decrease the number of components used therein. For example, Fig. 12 shows a configuration of a high-frequency block in a conventional mobile phone terminal. In the high-frequency block shown in Fig. 12, a reception path is connected with a inter-stage reception filter 104, and a transmission route is connected with a inter-stage transmission filter 114. On the other hand, a high-frequency block shown in Fig. 13 is configured such that the inter-stage transmission filter and the inter-stage reception filter are omitted for the purpose of simplifying the communication device. In this respect, the high-frequency block shown in Fig. 12 is provided with an antenna 101, a duplexer 102, a low noise amplifier (LNA) 103, a inter-stage reception filter 104, an LNA 105, mixers 106 and 109, low-pass filters (LPFs) 107 and 110, variable gain amplifiers (VGAs) 108 and 111, a phase control circuit 112, a transmitter 113, a inter-stage transmission filter 114 and a power amplifier (PA) 115. Also, on the high-frequency block shown in Fig. 13, in the reception side, the inter-stage reception filter 104 was omitted, and an LNA 202 was provided in places of the LNAs 103 and 105. Also, on the transmission side, the inter-stage transmission filter 114 was omitted.

In this way, in the high-frequency block shown in Fig. 13, since the number of the filter elements is decreased, the remaining filter element (duplexer 201) is demanded to have performances of the two conventional filter elements (inter-stage reception filter 104 and inter-stage transmission filter 114). Specifically, a great enhancement of out-of-band suppression, of the filter characteristic is demanded. Also, in addition to the above, a great enhancement of isolation between transmission and reception is demanded in the duplexer 201.

In this way, in the high-frequency filter and duplexer used for a mobile phone terminal and the like, there was involved such a problem that the suppression level outside a pass-band and the isolation must be greatly enhanced while continuously advancing a reduction in size and thickness.

As a factor to hinder the high suppression and high isolation of the filter and duplexer, there is exemplified unnecessary inductive and capacitive coupling generated in a substrate on which a filter element is mounted. Against this problem, for example, in a configuration disclosed in Patent Document 1, in a mounted package on which a filter element is mounted, it was contrived to enhance a suppression level of the filter by disposing a ground pattern (partitioning ground pattern) for partitioning a plurality of transmission lines present in one connecting line layer between the transmission lines, thereby suppressing unnecessary inductive and capacitive coupling between the transmission lines.

Here, for the purpose of suppressing the unnecessary inductive and capacitive coupling between the transmission lines, in the case of disposing a ground pattern on the same connecting line layer as those transmission lines, it would be better to make the ground pattern close to the transmission lines as far as possible. This is because electromagnetic fields radiated from the respective transmission lines are surely induced into the partitioning ground pattern, whereby the inductive and capacitive coupling between the respective transmission lines is reduced.

Patent Document 1: JP-A-2006-180192

US 2006/0076668 A1 discloses a multi-layer printed circuit board including a plurality of signal line layers and an insulating region arranged between each of the signal line layers, wherein a first insulating layer is arranged between the first signal layer and a ground layer.

WO 2008/001897 A1 discloses a noise suppressing structure including a first conductive layer, a second conductive layer, a noise suppressing layer provided between the first conductive layer and the second conductive layer, a first insulating layer provided between the first conductive layer and the noise suppressing layer, and a second insulating layer provided between the second conductive layer and the noise suppressing layer, wherein the noise suppressing structure has a first region in which the noise suppressing layer and the first conductive layer face each other, and a second region in which the noise suppressing layer and the first conductive layer do not face each other but the noise suppressing layer and the second conductive layer face each other, the first and second regions neighbouring each other.

JP 2004 166258 A discloses a balanced/unbalanced multiband filter module comprising high frequency switches each having a switching element and balanced/unbalanced band-pass filters of different pass frequency bands.

JP 2005 151287 A discloses an electronic component being a branching filter which consists of four layers and comprises a mounting substrate equipped with a first and a second filter, and resin dropped onto the filters to shield them, thus forming a chip size package structure. Moreover, two ground layers are formed in the mounting substrate so as to sandwich a phase matching circuit in the stack direction.

JP 2005 277522 A discloses an electronic component including first and second filters having band center frequencies different from each other, a board on the mount face of which the filters are mounted, first and second frame layers laminated and arranged on the board in a form surrounding the filters, a first ground line provided between the board and the first frame layer and electrically connected to ground terminals of the filters, a second ground line provided to the side of the second frame layer opposite to the side of the first frame layer, the second ground line electrically connected to the first ground line, and a phase line located between the first and second frame layers at a position sandwiched between the first and second ground lines and electrically connected to the first filter.

JP 2005 183949 A discloses a printed circuit board with low cross-talk noise comprising a common power plane having dielectric layers on opposing sides thereof and a signal layer on each of said dielectric layers, each signal layer comprising a plurality of substantially parallel signal lines running in substantially similar directions across said signal layers.

US 2004/212451 A1 discloses a duplexer including two surface acoustic wave (SAW) filters having different center frequencies, a phase matching circuit that matches phases of the two SAW filters, and a package in which the SAW filters and the phase matching circuit are housed. The package has a die-attached layer on which a chip of the SAW filters is facedown mounted, and ground line patterns provided on the die-attached layer and an underlying layer that underlies the die-attached layer.

EP 1 675 262 A2 discloses a duplexer including a transmission filter and a reception filter that have different band center frequencies from each other, a phase matching circuit that performs phase matching on the transmission filter and the reception filter, and a laminated package that includes a first layer on which the transmission filter, the reception filter, and the phase matching circuit are mounted.

US 2009/147707 A1 discloses a demultiplexer capable of improving attenuation characteristic and isolation characteristic of a filter having a lower transmission frequency band among two filters having different transmission frequency bands, outside the transmission frequency band of a high-frequency side.

### DISCLOSURE OF THE INVENTION

### PROBLEMS THAT THE INVENTION IS TO SOLVE

However, for a gap between the transmission line and the partitioning ground pattern, the same degree as a line width had to be ensured (line/space = 1/1); there was a limit in suppressing the unnecessary inductive and capacitive coupling; a signal of the filter outside a pass-band could not be greatly suppressed; and the isolation between transmission and reception could not be greatly enhanced.

An object of the invention is to provide a filter, a duplexer, a communication module and a communication device capable of suppressing unnecessary inductive and capacitive coupling in a substrate on which a filter element is mounted while realizing a reduction in size and thickness and having high suppression and high isolation characteristics.

### MEANS FOR SOLVING THE PROBLEMS

The problem is solved by the filter according to claim 1.

Preferred embodiments of the filter as well as a duplexer, a communication module and a communication device are subject to the dependent claims.

### ADVANTAGES OF THE INVENTION

According to the invention, it is possible to provide a filter and a duplexer having high suppression and high isolation. Also, since an outermost surface insulating layer of the substrate is reduced in thickness, there gives rise to an effect for enabling the prepared filter and duplexer to achieve a reduction in size and thickness. Also, when mounted with such a filter or duplexer, it is possible to realize a reduction in size and thickness of a communication module or a communication device.

### BRIEF DESCRIPTION OF THE DRAWINGS

Fig. 1A is a plan view of a filter according to an embodiment.
Fig. 1B is a sectional view of a Z-Z part in Fig. 1A.
Fig. 2A is a plan view showing a configuration of a first connecting line layer in a substrate on which a filter element is mounted.
Fig. 2B is a plan view showing a configuration of a second connecting line layer in a substrate on which a filter element is mounted.
Fig. 2C is a plan view showing a configuration of a third connecting line layer in a substrate on which a filter element is mounted.
Fig. 2D is a plan view showing a configuration of a fourth connecting line layer in a substrate on which a filter element is mounted.
Fig. 3 is a sectional view of a substrate on which a filter element is mounted.
Fig. 4 is a schematic view showing a state where a filter element and respective layers of a substrate are superimposed.
Fig. 5 is a circuit diagram of a duplexer.
Fig. 6 is a circuit diagram of a communication module using a duplexer of an embodiment.
Fig. 7 is a plan view showing a configuration of a duplexer.
Fig. 8 is a characteristic diagram showing frequency characteristics of a filter according to an embodiment and a conventional filter.
Fig. 9 is a characteristic diagram showing frequency characteristics of a filter according to an embodiment and a conventional filter.
Fig. 10 is a characteristic diagram showing a comparison of isolation by a disposal configuration of a ground pattern.
Fig. 11 is a block diagram showing a configuration of a communication device according to an embodiment.
Fig. 12 is a block diagram showing a configuration of a conventional high-frequency block.
Fig. 13 is a block diagram showing a configuration of a high-frequency block in the future.

### BEST MODES FOR CARRYING OUT THE INVENTION

A first filter of the invention is a filter comprising a substrate and a filter element mounted on the substrate, wherein the substrate is provided with a plurality of connecting line layers including a connecting line layer for the filter element which is formed with transmission lines and connected with the filter element, an insulating layer formed at a position interposed between the plural connecting line layers and a ground part formed in at least a part of the other connecting line layer under the connecting line layers for the filter element; and a thickness dimension of the insulating layer formed at a position interposed between the connecting line layer for the filter element and the other connecting line layer is smaller than a width dimension of the transmission line formed in the connecting line layer for the filter element and is larger than a thickness dimension of the other connecting line layer. According to such a configuration, not only the unnecessary inductive and capacitive coupling can be suppressed, but the isolation between reception and transmission can be greatly improved.

In the filter of the invention, it can be configured such that a thickness dimension of the insulating layer formed at a position interposed between the connecting line layer for the filter element and the other connecting line layer is not more than 75 % of a width dimension of the transmission line formed in the connecting line layer for the filter element and is larger than a thickness dimension of the other connecting line layer. It is more desirable to take such a configuration, a partitioning ground as in the conventional technology is not necessary, and there gives rise to such an effect that a degree of freedom for design of the connecting line pattern increases, and therefore, such is more desirable.

A second filter of the invention is a filter comprising a substrate and a filter element mounted on the substrate, wherein the substrate is provided with a plurality of connecting line layers including a connecting line layer for the filter element which is formed with transmission lines and connected with the filter element, an insulating layer formed at a position interposed between the plural connecting line layers and a ground part formed in at least a part of the other connecting line layer under the connecting line layers for the filter element; and a thickness dimension of the insulating layer formed at a position interposed between the connecting line layer for the filter element and the other connecting line layer is smaller than a distance between the most neighboring transmission lines in the connecting line layer for the filter element and is larger than a thickness dimension of the other connecting line layer. By taking such a configuration, in the case where a partitioning ground pattern cannot be disposed between the neighboring transmission lines, by making a thickness of an outermost surface insulating layer thinner than a distance between the transmission lines and neighboringly disposing a ground pattern of the other connecting line layer, thereby facing electromagnetic field radiations from the respective transmission lines toward the ground pattern, the unnecessary inductive and capacitive coupling between transmission lines can be suppressed. In this respect, the outermost surface insulating layer as referred to herein is an insulating layer on which the filter is mounted.

In the filter of the invention, it can be configured such that the ground part is disposed in at least a part of a region directly under two transmission lines including the most neighboring part among the transmission lines formed in the connecting line layer for the filter element. By taking such a configuration, electromagnetic fields radiated from the transmission lines of the connecting line layer for the filter element can be induced into the ground pattern directly thereunder, and radiation of the electromagnetic fields into surroundings can be suppressed.

In the filter of the invention, it can be configured such that the ground part is disposed in at least a part of a region directly under the filter element in the other connecting line layer. By taking such a configuration, the unnecessary inductive and capacitive coupling can be suppressed.

In the filter of the invention, it can be configured such that the ground part is disposed in at least a part of a region directly under a transmission line connected to a ground terminal of the filter element among the transmission lines formed in the connecting line layer for the filter element in the other connecting line layer. By taking such a configuration, the unnecessary inductive and capacitive coupling can be suppressed.

In the filter of the invention, it can be configured such that the substrate is formed of a ceramic material. By taking such a configuration, it becomes easy to seal the filter element 5 in an airtight manner. Furthermore, in general, the ceramic material is small in dielectric loss tangent, and a loss of each of a high-frequency filter and a duplexer can be kept small. In consequence, it is possible to realize a high-frequency filter and a duplexer with high suppression in a low loss.

In the filter of the invention, it can be configured such that the substrate is formed of a resin material. By taking such a configuration, in the case of mounting a plurality of filter elements on the substrate, even when the size of the substrate is large, it is possible to reduce a cost of the filter by using a resin-made printed wiring board.

In the filter of the invention, it can be configured such that at least an outermost surface insulating layer in the substrate is formed of a resin material and that at least a part of the other insulating layer in the substrate is formed of a ceramic material. In this way, by forming the outermost surface insulating layer using a resin which is in general easier for achieving a reduction in thickness than a ceramic, it is possible to easily prepare a thin outermost surface insulating layer. Also, by preparing the insulating layer other than the outermost surface insulating layer by using a ceramic having a characteristic feature that the dielectric loss tangent is small as compared with that of a resin, it is possible to prepare an insulating layer with small dielectric loss tangent. In consequence, advantages of the both materials can be effectively applied.

In the filter of the invention, the filter element is configured of an acoustic wave filter. By taking such a configuration, it is possible to realize a small-sized high-frequency filter and a duplexer in a low loss.

In the filter of the invention, it can be configured such that the filter element is mounted on the substrate by face down bonding.

In the filter of the invention, it can be configured such that the ground part is connected with a foot pattern for earth of the substrate by a plurality of vias between layers. By taking such a configuration, since a potential of the ground pattern disposed in the other connecting line layer becomes close to that of a true ground, an electromagnetic field radiated from the transmission line of the connecting line layer for the filter element advances more likely toward the ground pattern, and the unnecessary inductive and capacitive coupling between transmission lines can be suppressed.

### (Embodiment)

### [1. Configurations of filter and duplexer]

The invention has a characteristic feature from the principal structural standpoint such that the ground pattern is disposed more closely to the connecting line pattern which generates the unnecessary coupling as compared with the conventional technology.

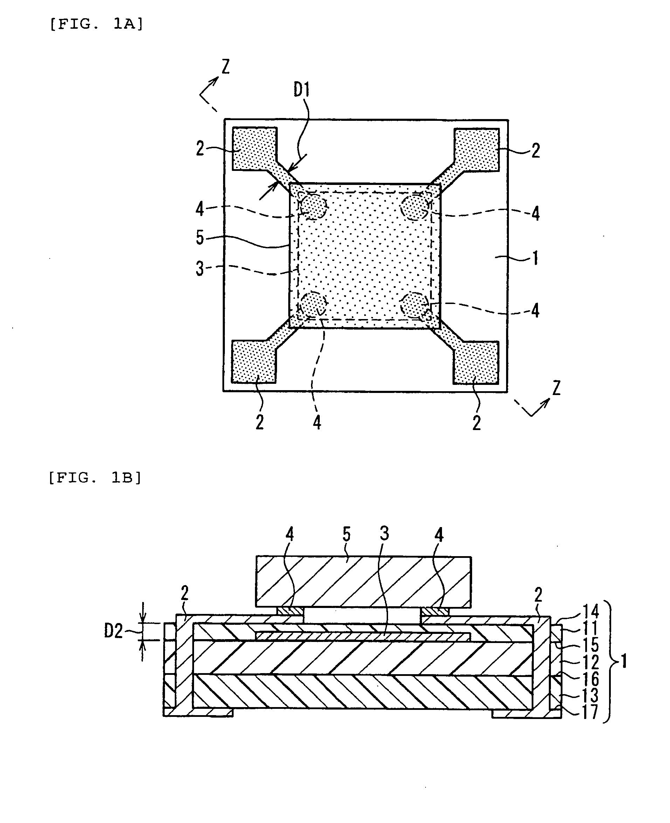

Fig. 1A is a plan view showing a configuration of a filter according to an embodiment. Fig. 1B is a sectional view of a Z-Z part in Fig. 1A. The filter according to the present embodiment is provided with a substrate 1, a transmission line 2, a ground pattern 3, a bonding pad part 4 and a filter element 5. In this respect, the ground pattern 3 is an example of the ground part of the invention.

The substrate 1 is provided with a first insulating layer 11, a second insulating layer 12 and a third insulating layer 13. A first connecting line layer 14 is formed on the filter mounting surface in the first insulating layer 11. In this respect, the first connecting line layer 14 according to the present embodiment is an example of the connecting line layer for the filter element of the invention. A second connecting line layer 15 is formed on the surface of the side of the first insulating layer 11 in the second insulating layer 12. Also, the ground pattern 3 is arranged in at least a part of the second connecting line layer 15. A third connecting line layer 16 is formed on the surface of the side of the second insulating layer 12 in the third insulating layer 13. Also, a fourth connecting line layer 17 is formed on the back surface relative to the surface on which the third connecting line layer 16 in the third insulating layer 13 is formed.

The wiring 2 is arranged in via formed penetrating from the first connecting line layer 14 to the fourth connecting line layer 17 of the substrate 1 and electrically conducts the back and front of the substrate 1 to each other. The bonding pad part 4 is electrically connected to one end of the wiring 2 (end of the side of the first connecting line layer 14) and arranged. The filter element 5 is electrically connected to the bonding pad part 4 and arranged.

For the purpose of suppressing the unnecessary inductive and capacitive coupling between transmission lines in the first connecting line layer 14 disposed on the filter mounting surface, the filter shown in Figs. 1A and 1B is configured such that the ground pattern 3 is disposed directly under the transmission line of the first connecting line layer 14 and that a thickness D2 of the first insulating layer 11 (outermost surface insulating layer) interposed between the first connecting line layer 14 and the second connecting line layer 15 positioning thereunder by one is thinner than a line width D1 of the wiring 2.

By taking such a configuration, in comparison with a configuration where a partitioning ground pattern is disposed within the same connecting line layer as in the conventional configuration, a distance between the transmission line in the first connecting line layer 14 and the ground pattern 3 can be shortened. This is because the ground pattern cannot be brought close to a level equal to or less than the line width within the same connecting line layer. That is, different from a conventional technology of arranging a transmission line and a ground pattern within the same plane, the present embodiment is configured such that by arranging the ground pattern 3 in a lower portion of the first connecting line layer 14 (namely, disposing the transmission line and the ground pattern within a different plane from each other), the distance between the transmission line of the first connecting line layer 14 and the ground pattern 3 can be brought close to each other.

In this respect, in order to keep electrical insulation between the first connecting line layer 14 and the second connecting line layer 15, it is necessary that a lower limit of the thickness D2 of the first insulating layer 11 is larger than the thickness of the second connecting line layer 15.

Also, since the outermost surface insulating layer (first insulating layer 11) is reduced in thickness, the invention is **characterized in that** a high-frequency filter and a duplexer prepared using such a substrate 1 can be reduced in thickness as compared with conventional ones.

### (Example)

Example of the filter of the invention is described with reference to a duplexer configured such that two filter elements are mounted on a low temperature co-fired ceramics (LTCC) substrate. In this respect, this duplexer is a duplexer for Band 1 (transmission band: 1,920 to 1,980 MHz, reception band: 2, 110 to 2,170 MHz) of a third-generation mobile phone W-CDMA system.

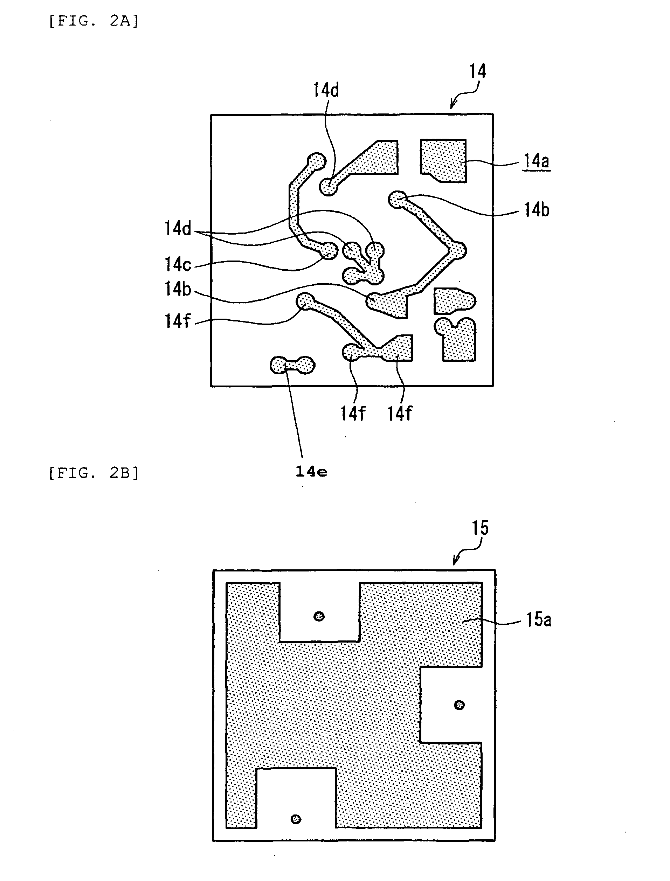

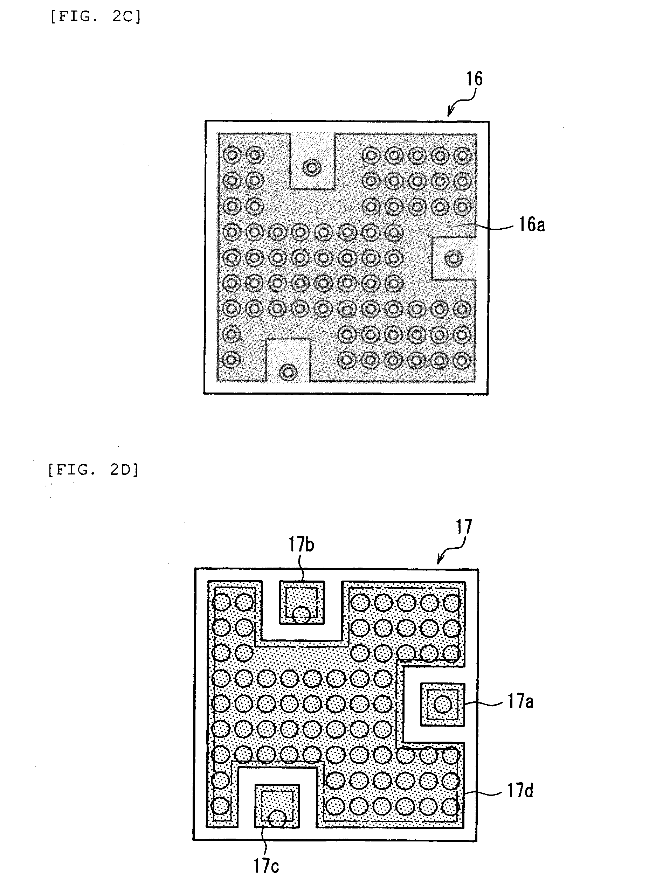

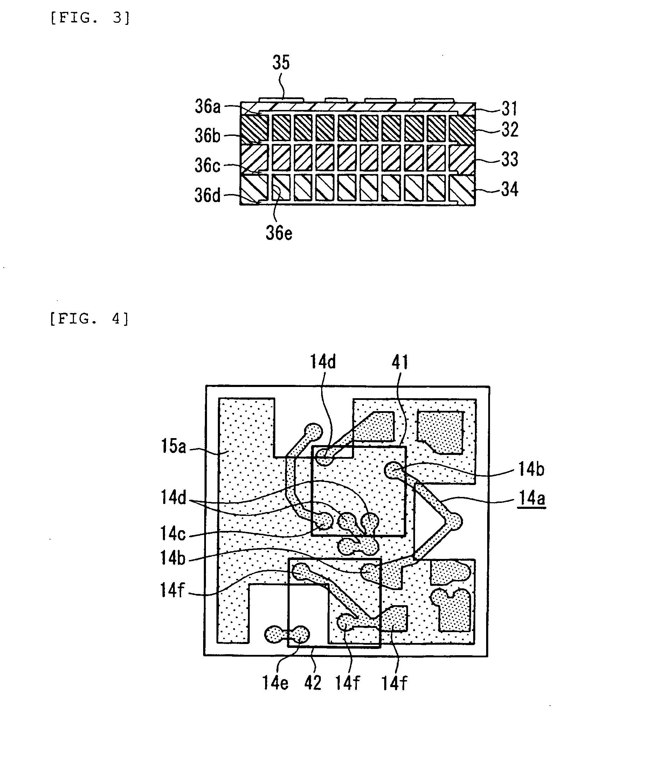

Each of Figs. 2A to 2D shows a configuration of each of layers of the substrate of the prepared duplexer. Fig. 3 shows a sectional view of the substrate of the duplexer. As shown in Fig. 2A, a connecting line pattern 14a is formed in the first connecting line layer 14 on which the filter element 5 is mounted. The connecting line pattern 14a is provided with an antenna terminal 14b, a reception terminal 14c, a ground terminal 14d of a reception filter, a transmission terminal 14e and a ground terminal 14f of a reception filter. As shown in Fig. 2B, a ground pattern 15a for suppressing the unnecessary inductive and capacitive coupling is disposed in the second connecting line layer 15. This ground pattern 15a is corresponding to the ground pattern 3 shown in Figs. 1A and 1B. The ground pattern 15a is electrically connected to a ground 17d of a foot pattern in the fourth connecting line layer 17 shown in Fig. 2D with a plurality of vias between layers via the second connecting line layer 15 and the third connecting line layer 16 shown in Fig. 2C.

In this respect, with respect to the thickness of the insulating layer, the outermost surface insulating layer (first insulating layer 11) was set up at 25 µm. Also, a substrate whose thickness of the outermost surface insulating layer was set up at 100 µm was prepared for comparison. A thickness of each of the second insulating layer 12, the third insulating layer 13 and the fourth insulating layer 14 was set up at 100 µm. Also, those shown in Table 1 can be properly used as the insulating layer.

**[Table 1]**

| Ceramic material | Dielectric constant |
|---|---|
| A | 7 |
| B | 27 |
| C | 81 |
| D | 125 |
| E | 7.8 |
| F | 9 |

Fig. 4 shows a mutual positional relation among the filter element 5, the connecting line pattern 14a of the first connecting line layer 14 and the ground pattern 15a of the second connecting line layer 15. Also, Fig. 4 shows a positional relation of the respective layers when seeing the substrate 1 in a normal line direction of its principal plane. As shown in Fig. 4, in a reception filter 41, the ground pattern 15a is disposed in the second conductor layer 15 over the substantially entire surface directly thereunder. In a transmission filter 42, the ground pattern 15a of the second conductor layer 15 is not disposed directly under a signal line connected to the transmission terminal 14e, and the ground pattern 15a is disposed in a region including one directly under the transmission line connected to other ground terminal (ground terminal 14d of the reception filter 41). In this respect, a line width of the connecting line pattern is formed to be 100 µm, and a line/space is 100/100 µm as a design rule.

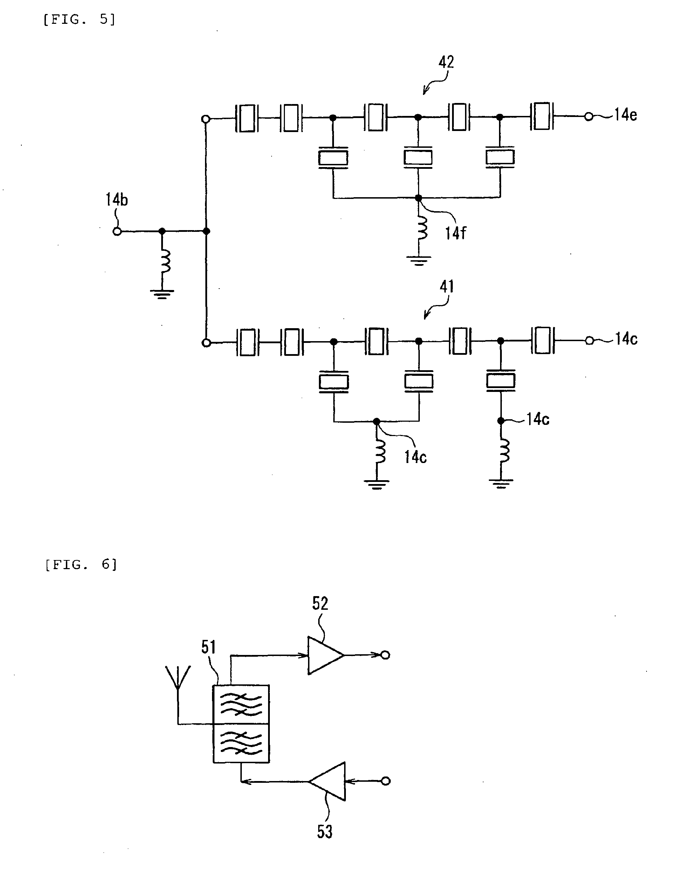

Fig. 5 shows a circuit diagram of a duplexer. The reception filter 41 and the transmission filter 42 are configured in a ladder type filter in which FBAR filters are connected to each other in a ladder shape.

Fig. 6 shows a configuration of a communication module provided with the duplexer according to the present embodiment. The communication module is provided with a duplexer 51, a low noise amplifier (LNA) 52 and a power amplifier (PA) 53. The duplexer 51 is configured of the duplexer according to the present embodiment.

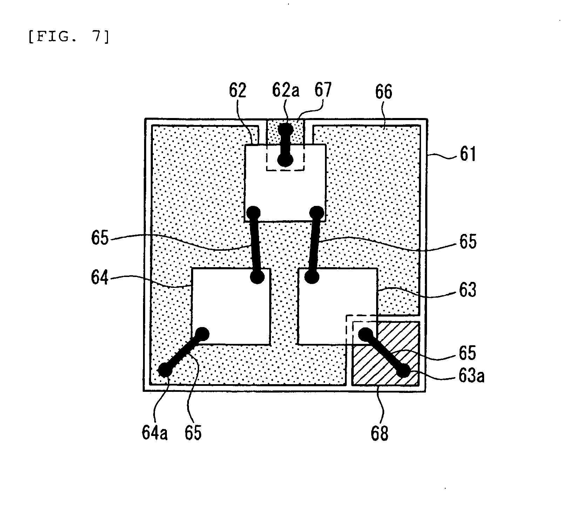

Fig. 7 shows a mounting configuration of the duplexer according to the present invention. As shown in Fig. 7, the duplexer is provided with a phase matching circuit 62, a reception SAW filter 63 and a transmission SAW filter 64 on a substrate 61. The phase matching circuit 62 is connected to an antenna port 62a and also connected to each of the reception SWA filter 63 and the transmission SAW filter 64 via a transmission line 65 formed in the first connecting line layer 14 (see Fig. 1B). The reception SAW filter 63 is connected to a reception port 63a via the transmission line 65 formed in the first connecting line layer 14. The transmission SAW filter 64 is connected to a transmission port 64a via the transmission line 65 formed in the first connecting line layer 14. The duplexer shown in Fig. 7 includes three kinds of different impedances (impedances of the antenna port 62a, the reception SAW filter 63 and the transmission SAW filter 64), and in the case of taking such a configuration, it is necessary to arrange a ground corresponding to each of the impedances. A first ground pattern 66 is formed in the second connecting line layer 15 (see Fig. 1B) and connected with the transmission port 64a. A second ground pattern 67 is formed in the third connecting line layer 16 (see Fig. 1B) and connected with the antenna port 62a. A third ground pattern 68 is formed in the fourth connecting line layer 17 (see Fig. 1B) and connected with the reception port 63a.

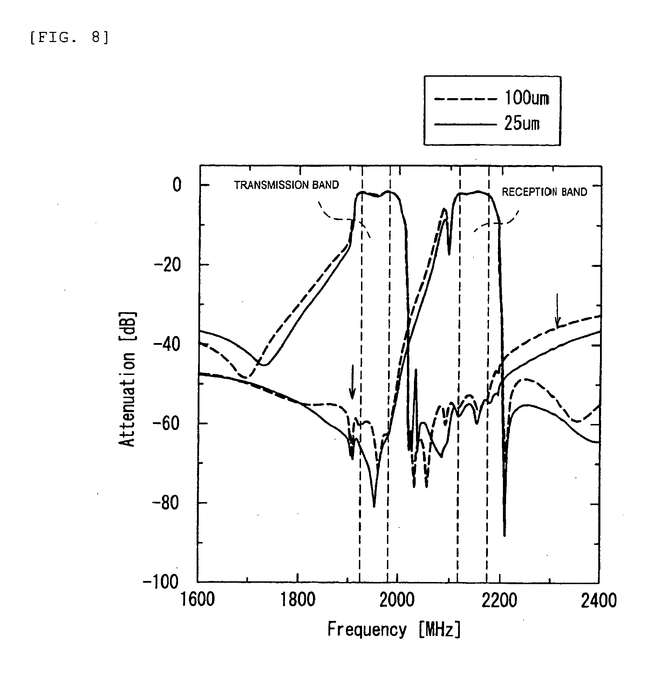

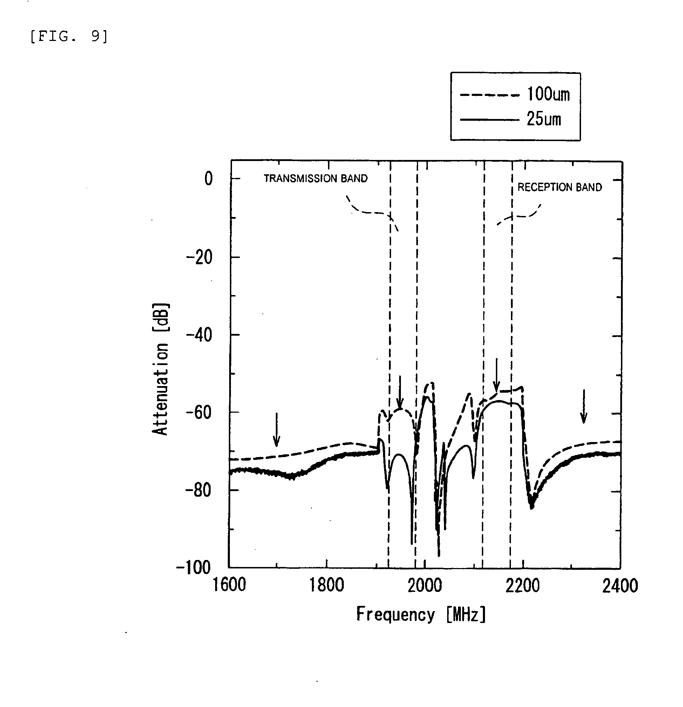

Fig. 8 shows a transmission/reception characteristic in the duplexer shown in Fig. 5. Fig. 9 shows isolation between the reception filter 41 and the transmission filter 42 in the duplexer shown in Fig. 5. The characteristics shown in Figs. 8 and 9 are the results obtained by measuring electrical characteristics using the duplexer shown in Fig. 5. As the duplexer used for the measurement, there were prepared one in which the thickness of the outermost surface insulating layer (first insulating layer 11) of the filter was set up at 100 µm, a value of which is equal to the connecting line pattern width; and one in which the thickness of the outermost surface insulating layer (first insulating layer 11) was set up at 25 µm. As a result of evaluating the respective duplexers, it was noted that as shown by the solid-line characteristics in Fig. 8, in the case of setting up the thickness of the outermost surface insulating layer at 25 µm, the suppression level can be improved over a wide frequency band. Also, as shown by the solid-line characteristics in Fig. 9, in particular, it was noted that the isolation of the transmission band can be reduced by 12 dB and that the isolation can be greatly improved.

In this respect, in the case of disposing the partitioning ground pattern in the same layer as the connecting line layer as in the conventional technology, since the suppression level and isolation are limited to the case where the distance between the connecting line pattern and the ground pattern is up to 100 µm, they are equal to the characteristics shown by the broken lines in Figs. 8 and 9 (characteristics when the thickness of the insulating layer is set up at 100 µm).

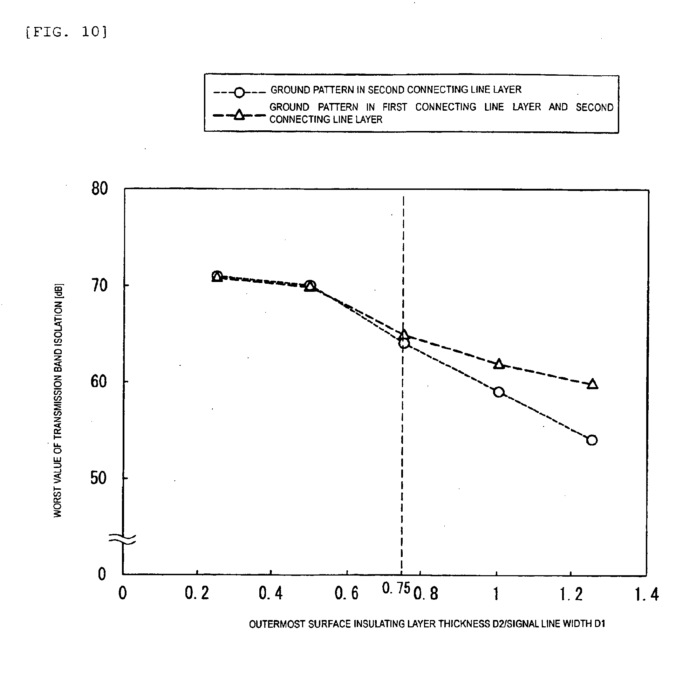

Fig. 10 shows a change of the transmission band isolation relative to the thickness of the outermost surface insulating layer. Also, Fig. 10 shows the results obtained by calculating characteristics of the duplexer when a partitioning ground pattern was disposed while providing a gap of 100 µm between the connecting line patterns of the first connecting line layer 14, according to the electromagnetic field simulation. In this respect, the thickness of the outermost surface insulating layer (first insulating layer 11) was also changed. An abscissa of Fig. 10 represents a ratio of the thickness of the outermost surface insulating layer to the connecting line pattern width. As shown in Fig. 10, by regulating the ratio of the thickness of the outermost surface insulating layer to the connecting line pattern width to not more than 0.75, the effect by the partitioning ground pattern vanishes, and thus, it was noted that the isolation is determined only by the effect of the ground pattern 3 formed in the second connecting line layer 15. Namely, it was noted that when the ratio of the thickness of the outermost surface insulating layer to the connecting line pattern width is not more than 0.75, the partitioning ground is not necessary and that there gives rise to such an effect that a degree of freedom for design of the connecting line pattern increases.

### [2. Configuration of communication device]

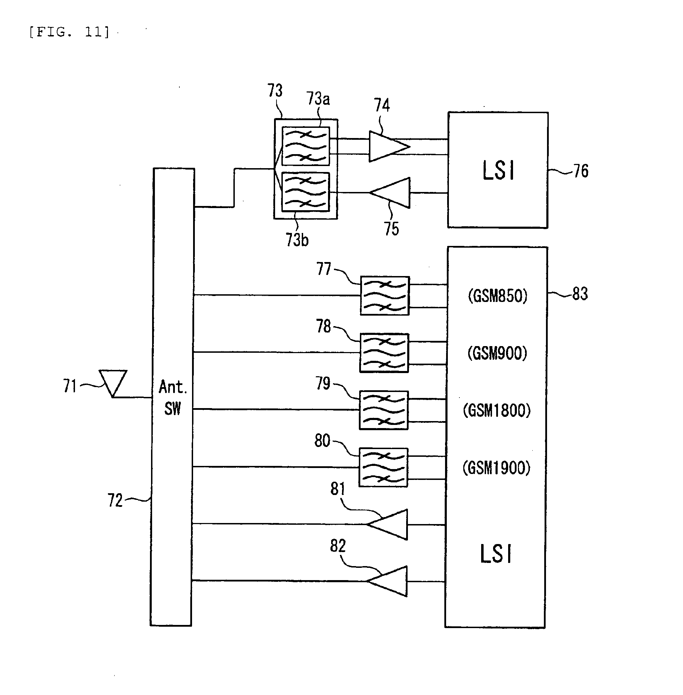

Fig. 11 shows an RF block of a mobile phone terminal as an example of a communication device provided with the filter or duplexer according to the present embodiment. Also, the configuration shown in Fig. 11 shows a configuration of a mobile phone terminal corresponding to a GSM (global system for mobile communications) communication system and a W-CDMA (wideband code division multiple access) communication system. Also, the GSM communication system in the present embodiment is corresponding to an 850 MHz band, a 950 MHz band, a 1.8 GHz band and a 1. 9 GHz band, respectively. Also, though the mobile phone terminal is provided with a microphone, a speaker, a liquid crystal display and the like in addition to the configuration shown in Fig. 11, since they are unnecessary in the explanation in the present embodiment, the illustration was omitted. Here, the filter according to the present embodiment is included in each of reception filters 73a, 77, 78, 79 and 80 and a transmission filter 73b. Also, a duplexer 73 can be configured of the duplexer according to the present embodiment.

First of all, with respect to a received signal inputted via an antenna 71, LSI which is a subject of the action is chosen by an antenna switching circuit 72 depending upon whether the communication system is W-CDMA or GSM. In the case where the inputted received signal is corresponding to the W-CDMA communication system, switching is performed so as to output the received signal into the duplexer 73. The received signal inputted into the duplexer 73 is limited to a prescribed frequency band by the reception filter 73a, and a balance type received signal is outputted into an LNA 74. The LNA 74 amplifies the inputted received signal and outputs it into an LSI 76. The LSI 76 performs demodulation processing into an audio signal on the basis of the inputted received signal or performs action control of each of the components within the mobile phone terminal.

On the other hand, in the case of transmitting a signal, the LSI 76 produces a transmitting signal. The produced transmitting signal is amplified by a power amplifier 75 and inputted into the transmission filter 73b. The transmission filter 73b allows only a signal of a prescribed frequency band among the inputted transmitting signal to pass therethrough. The transmitting signal outputted from the transmission filter 73b is outputted to the outside from the antenna 71 via the antenna switching circuit 72.

Also, in the case where the inputted received signal is a signal corresponding to the GSM communication system, the antenna switching circuit 72 chooses any one of the reception filters 77 to 80 depending upon the frequency band and outputs a received signal. The received signal whose band has been limited by any one of the reception filters 77 to 80 is inputted into an LSI 83. The LSI 83 performs demodulation processing into an audio signal on the basis of the inputted received signal or performs action control of each of the components within the mobile phone terminal. On the other hand, in the case of transmitting a signal, the LSI 83 produces a transmitting signal. The produced transmitting signal is amplified by a power amplifier 81 or 82 and outputted to the outside from the antenna 71 via the antenna switching circuit 72.

In the light of the above, by providing the communication device with the filter or duplexer according to the present embodiment, not only the unnecessary inductive and capacitive coupling can be suppressed, but the isolation between reception and transmission can be enhanced. In consequence, the communication quality can be enhanced. Also, according to the present embodiment, since the outermost surface insulating layer (first insulating layer 11) is reduced in thickness, it is able to contribute to a reduction in thickness of a communication device.

### [3. Effects, etc. of embodiment]

By making the thickness D2 of the outermost surface insulating layer (first insulating layer 11) thinner than the connecting line pattern width D1 and disposing the ground pattern 3 in the connecting line layer positioning thereunder by one as in the present embodiment, not only the unnecessary inductive and capacitive coupling can be suppressed, but the isolation between reception and transmission can be greatly improved.

Also, according to the present embodiment, since the outermost surface insulating layer (first insulating layer 11) is reduced in thickness, it is possible to achieve a reduction in size and thickness of a filter and a duplexer. By mounting such a filter or duplexer on a communication module or a communication device, it is possible to achieve a reduction in size and thickness of the communication module or communication device.

Also, on the basis of the results of experiments made by the present inventors, as shown in Fig. 10, by regulating the thickness D2 of the outermost surface insulating layer (first insulating layer 11) to not more than 75 % of the line width D1 of the transmission line 2, a partitioning ground pattern as in the conventional technology is not necessary, and there gives rise to such an effect that a degree of freedom for design of the connecting line pattern increases; and thus, such is more desirable.

Also, the effect is obtained by making the thickness D2 of the outermost surface insulating layer (first insulating layer 11) thinner than a distance between the neighboringly disposed transmission lines. This is because in the case where the partitioning ground pattern cannot be disposed between the neighboring transmission lines, by making the thickness D2 of the outermost surface insulating layer (first insulating layer 11) thinner than the distance between the transmission lines and neighboringly disposing the ground pattern 3 of the second connecting line layer 15, the unnecessary inductive and capacitive coupling between transmission lines can be suppressed while facing the electromagnetic field radiations from the respective transmission lines toward the ground pattern 3.

Also, it is desirable that the ground pattern 3 disposed in the second connecting line layer 15 is disposed directly under of the transmission line of the first connecting line layer 14. By taking such a configuration, electromagnetic fields radiated from the transmission line of the connecting line layer for the filter element 14 can be induced into the ground pattern 3 directly thereunder, and radiation of the electromagnetic fields into surroundings can be suppressed.

Also, it is desirable that the ground pattern 3 disposed in the second connecting line layer 15 is disposed directly under the transmission line having the most neighboring part in the first connecting line layer 14. By taking such a configuration, in the most neighboring part where the unnecessary inductive and capacitive coupling is the most remarkable, electromagnetic field radiations from the respective transmission lines can be induced into the ground pattern 3 directly thereunder, and the inductive and capacitive coupling between transmission lines can be suppressed.

Also, it is desirable that the ground pattern 3 disposed in the second connecting line layer 15 is disposed directly under the filter element 5. This is because as shown in Fig. 1A, a plurality of the pads 4 for bonding the filter element 5 are present in the first connecting line layer 14 directly under the filter element 5; and the bonding pads 4 are disposed neighboringly each other, and they become a factor to cause the unnecessary inductive and capacitive coupling. In consequence, by disposing the ground pattern 3 directly under the filter element 5, the unnecessary inductive and capacitive coupling can be suppressed.

Also, it is desirable that the ground pattern 3 disposed in the second connecting line layer 15 is disposed directly under the transmission line connected to the ground terminal of the filter element 5 in the first connecting line layer 14. This is because when the ground pattern 3 is disposed neighboringly directly under the transmission line connected to the signal terminal of the filter element 5, the characteristic impedance of the transmission line changes and deteriorates a filter passing characteristic, whereas according to the configuration in which the ground pattern 3 is disposed directly under the transmission line connected to the ground terminal, the deterioration of a filter characteristic to be caused due to the impedance change is so small that it is negligible, and only the effect for suppressing the unnecessary inductive and capacitive coupling is obtainable.

Also, it is desirable that a material on which the filter is mounted is a ceramic. By taking such a configuration, it becomes easy to seal the filter element 5 in an airtight manner. Furthermore, in general, the ceramic material is small in dielectric loss tangent, and a loss of each of a high-frequency filter and a duplexer can be kept small. In consequence, it is possible to realize a high-frequency filter and a duplexer with high suppression in a low loss.

Also, in the case of mounting a plurality of the filter elements 5 on the substrate 1, a material of the substrate 1 may be a resin. By taking such a configuration, in the case of mounting a plurality of the filter elements 5 on the substrate 1, even when the size of the substrate 1 is large, it is possible to reduce a cost of the filter by using a resin-made printed wiring board.

Also, in the substrate 1 on which the filter element 5 is mounted, the outermost surface insulating layer (first insulating layer 11) can be formed of a resin material, and the other insulating layer can be formed of a ceramic. In this way, by forming the outermost surface insulating layer by using a resin which is in general easier to achieve a reduction in thickness than a ceramic, a thin outermost surface insulating layer can be easily prepared. Also, by preparing the insulating layer other than the outermost surface insulating layer by using a ceramic having such a characteristic feature that the dielectric loss tangent is small as compared with that of a resin, it is possible to prepare an insulating layer with small dielectric loss tangent. In consequence, advantages of the both materials can be effectively applied.

Also, the filter element 5 can be configured of a surface acoustic wave filter (SWA filter) or a thin bulk acoustic resonator filter (FBAR filter). By taking such a configuration, it is possible to realize a small-sized high-frequency filter and a duplexer in a low loss.

Also, it is desirable that the filter element 5 is mounted on the substrate 1 by face down bonding.

Also, it is desirable that the ground pattern 3 disposed in the second connecting line layer 15 is connected with a foot pattern for earth by a plurality of vias between layers. This is because a potential of the ground pattern 3 disposed in the second connecting line layer 15 becomes close to that of a true ground, and therefore, an electromagnetic field radiated from the transmission line of the first connecting line layer 14 advances more likely toward the ground pattern 3, and the unnecessary inductive and capacitive coupling between transmission lines can be suppressed.

### INDUSTRIAL APPLICABILITY

The filter, the duplexer, the communication module and the communication device of the invention are useful for equipment capable of receiving or transmitting a signal of a prescribed frequency.

## Claims

1. A filter comprising a substrate (1) and a filter element (5) mounted on the substrate (1), wherein
the substrate (1) is provided with
a plurality of connecting line layers (14, 15, 16, 17) including a first (14) and a second (15) connecting line layer, the first connecting line layer (14) being for the filter element (5) which is formed with transmission lines (2) and connected with the filter element (5),
an insulating layer (11) interposed between the first connecting line layer (14) and the second connecting line layer (15), and
a ground part (3, 15a) formed in at least a part of the second connecting line layer (15) under the first connecting line layer (14) for the filter element (5); wherein
a thickness dimension D2 of the insulating layer (11) interposed between the first connecting line layer (14) for the filter element (5) and the second connecting line layer (15) is smaller than a width dimension D1 of each of the transmission lines (2) formed in the first connecting line layer (14) for the filter element (5) or smaller than a distance between the most neighboring transmission lines among the transmission lines (2) in the first connecting line layer (14) for the filter element (5), and is larger than a thickness dimension of the second connecting line layer (15); and wherein
at least an outermost surface insulating layer (11) in the substrate (1) is formed of a resin material; and
at least a part of other insulating layer (12, 13) in the substrate (1) is formed of a ceramic material.

2. The filter according to claim 1, wherein
the thickness dimension D2 of the insulating layer (11) formed at a position interposed between the first connecting line layer (14) for the filterelement (5) and the second connecting line layer (15) is not more than 75 % of the width dimension D1 of each of the transmission lines (2) formed in the first connecting line layer (14) for the filter element (5) and is larger than the thickness dimension of the second connecting line layer (15).

3. The filter according to claims 1 or 2, wherein
the ground part (3, 15a) is disposed in at least a part of a region directly under two transmission lines including the most neighboring part among the transmission lines (2) formed in the first connecting line layer (14) for the filter element (5).

4. The filter according to any one of claims 1 to 3, wherein the ground part (3, 15a) is disposed in at least a part of a region directly under the filter element (5) in the second connecting line layer (15).

5. The filter according to any one of claims 1 to 4, wherein
the ground part (3, 15a) is disposed in at least a part of a region directly under a transmission line (2) connected to a ground terminal (14d, 14f) of the filter element (5) among the transmission lines (2) formed in the first connecting line layer (14) for the filter element (5) in the second connecting line layer (15).

6. The filter according to any one of claims 1 to 5, wherein
the substrate (1) is formed of a ceramic material.

7. The filter according to any one of claims 1 to 6, wherein
the substrate (1) is formed of a resin material.

8. The filter according to any one of claims 1 to 7, wherein
the filter element (5) is configured of an acoustic wave filter.

9. The filter according to claim 8, wherein
the filter element (5) is mounted on the substrate (1) by face down bonding.

10. The filter according to any one of claims 1 to 9, wherein
the ground part (3, 15a) is connected with a foot pattern for earth of the substrate (1) by a plurality of vias between layers.

11. A duplexer (51; 73) comprising the filter according to any one of claims 1 to 10.

12. A communication module comprising the filter according to any one of claims 1 to 10 or the duplexer (51; 73) according to claim 11.

13. A communication device comprising the communication module according to claim 12.

## Patentansprüche

1. Ein Filter, der ein Substrat (1) und ein auf dem Substrat (1) montiertes Filterelement (5) umfasst, wobei
das Substrat (1) über Folgendes verfügt:
eine Vielzahl an Verbindungslinien-Ebenen (14, 15, 16, 17), die eine erste (14) und eine zweite (15) Verbindungslinien-Ebene beinhalten, wobei die erste Verbindungslinien-Ebene (14) für das Filterelement (5) ist, die mit Übertragungslinien (2) gebildet wird, und mit dem Filterelement (5) verbunden ist,
eine Isolier-Ebene (11), die zwischen der ersten Verbindungslinien-Ebene (14) und der zweiten Verbindungslinien-Ebene (15) eingefügt wird, und
ein Bodenteil (3, 15a), das in zumindest einem Teil der zweiten Verbindungslinien-Ebene (15) unter der ersten Verbindungslinien-Ebene (14) für das Filterelement (5) gebildet wird; wobei
eine Dickenabmessung D2 der Isolier-Ebene (11), die zwischen der ersten Verbindungslinien-Ebene (14) für das Filterelement (5) und der zweiten Verbindungslinien-Ebene (15) eingefügt ist, kleiner ist als eine Breitenabmessung D1 jede unter den Übertragungslinien (2), die in der ersten Verbindungslinien-Ebene (14) für das Filterelement (5) gebildet werden, oder kleiner ist als ein Abstand zwischen den am engsten benachbarten Übertragungslinien unter den Übertragungslinien (2) in der ersten Verbindungslinien-Ebene (14) für das Filterelement (5), und größer ist als eine Dickenabmessung der zweiten Verbindungslinien-Ebene (15); und wobei
mindestens eine äußerste Fläche Isolier-Ebene (11) im Substrat (1) aus einem Harzwerkstoff gebildet wird; und
mindestens ein Teil einer anderen Isolier-Ebene (12, 13) im Substrat (1) aus einem keramischen Werkstoff gebildet wird.

2. Der Filter nach Anspruch 1, wobei
die Dickenabmessung D2 der Isolier-Ebene (11), die an einer Stelle zwischen der ersten Verbindungslinien-Ebene (14) für das Filterelement (5) und der zweiten Verbindungslinien-Ebene (15) gebildet wird, nicht mehr als 75% der Breitenabmessung D1 einer jeden unter den Übertragungslinien (2) entspricht, die in der ersten Verbindungslinien-Ebene (14) für das Filterelement (5) gebildet werden, und größer ist als die Dickenabmessung der zweiten Verbindungslinien-Ebene (15).

3. Der Filter nach Anspruch 1 oder 2, wobei
der Bodenteil (3, 15a) zumindest in einem Teil einer Zone direkt unter zwei Übertragungslinien angeordnet wird, einschließlich den am engsten benachbarten Teil unter den in der ersten Verbindungslinien-Ebene (14) für das Filterelement (5) gebildeten Übertragungslinien (2).

4. Der Filter nach einem der Ansprüche von 1 bis 3, wobei der Bodenteil (3, 15a) zumindest in einem Teil einer Zone direkt unter dem Filterelement (5) in der zweiten Verbindungslinien-Ebene (15) angeordnet wird.

5. Der Filter nach einem der Ansprüche von 1 bis 4, wobei
der Bodenteil (3, 15a) zumindest in einem Teil einer Zone direkt unter einer Übertragungslinie (2) angeordnet wird, die mit einer Erdung (14d, 14f) des Filterelements (5) verbunden ist, unter den in der ersten Verbindungslinien-Ebene (14) für das Filterelement (5) gebildeten Übertragungslinien (2), der zweiten Verbindungslinien-Ebene (15).

6. Der Filter nach einem der Ansprüche von 1 bis 5, wobei
das Substrat (1) aus einem keramischen Werkstoff gebildet wird.

7. Der Filter nach einem der Ansprüche von 1 bis 6, wobei das Substrat (1) aus einem Harz-Werkstoff gebildet wird.

8. Der Filter nach einem der Ansprüche von 1 bis 7, wobei
das Filterelement (5) als ein akustischer Wellenfilter konfiguriert ist.

9. Der Filter nach Anspruch 8, wobei
das Filterelement (5) durch nach unten gerichtetes Bonding (*face down bonding*) auf dem Substrat (1) montiert wird.

10. Der Filter nach einem der Ansprüche von 1 bis 9, wobei
der Bodenteil (3, 15a) mit einer Fußstruktur (*foot pattern*) zur Erdung des Substrats (1) durch eine Vielzahl an Wegen zwischen den Ebenen verbunden wird.

11. Ein Duplexer (51; 73) den Filter nach einem der Ansprüche von 1 bis 10 umfassend.

12. Ein Kommunikationsmodul, das den Filter nach einem der Ansprüche von 1 bis 10 oder den Duplexer (51; 73) nach Anspruch 11 umfasst.

13. Eine Kommunikationsvorrichtung, das Kommunikationsmodul nach Anspruch 12 umfassend.

## Revendications

1. Un filtre comprenant un substrat (1) et un élément filtre (5) monté sur le substrat (1), sachant que
le substrat (1) est doté
d'une pluralité de couches de lignes de connexion (14, 15, 16, 17) incluant une première (14) et une deuxième (15) couche de lignes de connexion, la première couche de lignes de connexion (14) étant pour l'élément filtre (5), qui est formé avec des lignes de transmission (2), et raccordé à l'élément filtre (5),
d'une couche isolante (11) interposée entre la première couche de lignes de connexion (14) et la deuxième couche de lignes de connexion (15), et
d'une pièce de mise à terre (*ground part*) (3, 15a) formée dans au moins une partie de la deuxième couche de lignes de connexion (15) au-dessous de la première couche de lignes de connexion (14) pour l'élément filtre (5) ; sachant que
une dimension épaisseur D2 de la couche isolante (11), interposée entre la première couche de lignes de connexion (14) pour l'élément filtre (5) et la deuxième couche de lignes de connexion (15), est plus petite qu'une dimension largeur D1 de chacune des lignes de transmission (2) formées dans la première couche de lignes de connexion (14) pour l'élément filtre (5), ou bien est plus petite qu'une distance entre les lignes de transmission réciproquement les plus proches parmi les lignes de transmission (2) formées dans la première couche de lignes de connexion (14) pour l'élément filtre (5), et plus grande qu'une dimension d'épaisseur de la deuxième couche de lignes de connexion (15) ; et sachant que
au moins une couche isolante (11) de surface la plus extérieure dans le substrat (1) est formée d'un matériau à base de résine ; et que
au moins une partie de l'autre couche isolante (12, 13) dans le substrat (1) est formée d'un matériau céramique.

2. Le filtre d'après la revendication 1, sachant que
la dimension épaisseur D2 de la couche isolante (11), formée à une position interposée entre la première couche de lignes de connexion (14) pour l'élément filtre (5) et la deuxième couche de lignes de connexion (15), n'est pas plus grande que 75% de la dimension largeur D1 de chacune des lignes de transmission (2) formées dans la première couche de lignes de connexion (14) pour l'élément filtre (5), et plus grande que la dimension d'épaisseur de la deuxième couche de lignes de connexion (15).

3. Le filtre d'après la revendication 1 ou 2, sachant que
la pièce de mise à terre (3, 15a) est disposée dans au moins une partie d'une zone directement au-dessous de deux lignes de transmission, y compris la partie la plus proche parmi les lignes de transmission (2) formées dans la première couche de lignes de connexion (14) pour l'élément filtre (5).

4. Le filtre d'après une des revendications de 1 à 3, sachant que la pièce de mise à terre (3, 15a) est disposée dans au moins une partie d'une zone directement au-dessous de l'élément filtre (5) dans la deuxième couche de lignes de connexion (15).

5. Le filtre d'après une des revendications de 1 à 4, sachant que
la pièce de mise à terre (3, 15a) est disposée dans au moins une partie d'une zone directement au-dessous d'une ligne de transmission (2) raccordée à une borne de mise à terre (14d, 14f) de l'élément filtre (5) parmi les lignes de transmission (2) formées dans la première couche de lignes de connexion (14) pour l'élément filtre (5), dans la deuxième couche de lignes de connexion (15).

6. Le filtre d'après une des revendications de 1 à 5, sachant que
le substrat (1) est formé d'un matériau céramique.

7. Le filtre d'après une des revendications de 1 à 6, sachant que
le substrat (1) est formé d'un matériau à base de résine.

8. Le filtre d'après une des revendications de 1 à 7, sachant que
l'élément filtre (5) est configuré en tant que filtre à ondes acoustiques.

9. Le filtre d'après la revendication 8, sachant que
l'élément filtre (5) est monté sur le substrat (1) par liaison vers le bas (*face down bonding*).

10. Le filtre d'après une des revendications de 1 à 9, sachant que
la pièce de mise à terre (3, 15a) est connectée avec un modèle de pied (foot *pattern*) pour la mise à terre du substrat (1) par une pluralité de chemins entre les couches.

11. Un duplexeur (51 ; 73) comprenant le filtre d'après une des revendications de 1 à 10.

12. Un module de communication comprenant le filtre d'après une des revendications de 1 à 10 ou bien le duplexeur (51 ; 73) d'après la revendication 11.

13. Un dispositif de communication comprenant le module de communication d'après la revendication 12.
